# EUROPEAN PATENT APPLICATION

(11) **EP 4 626 184 A1**
(43) Date of publication of application: **01.10.2025**
(21) Application number: 25159000.6
(22) Date of filing: 20.02.2025
(51) Int. Cl.: H10F 71/00

(54) **BENDING DEVICE AND TABBING APPARATUS INCLUDING THE SAME**

(30) Priority: 22.02.2024 KR 20240025914
(71) Applicant: Hanwha Solutions Corporation, Jung-gu Seoul 04541 (KR)
(72) Inventor: JUNG, Min Kyo, 04541 Seoul (KR); BAEK, Dong Heon, 04541 Seoul (KR); CHUNG, Dong Jin, 04541 Seoul (KR)
(74) Representative: Mooser, Sebastian Thomas

(57) **Abstract**

The present disclosure relates to a bending device and a tabbing apparatus including the same, and the bending device includes a stage on which a solar cell having a first surface and a second surface spaced apart from each other in a first direction is seated, and a bending unit spaced apart from the stage and configured to press a wire disposed on the first surface in the first direction.

## Description

### BACKGROUND

### 1. Field of the Invention

The present disclosure relates to a bending device and a tabbing apparatus including the same, and more specifically, to a bending device and a tabbing apparatus including the same, in which wires are processed so that solar cells can be connected in series in a tabbing process.

### 2. Discussion of Related Art

In general, a solar cell is formed by arranging p-n junction diodes on a substrate. When a solar cell is irradiated with sunlight, an exciton, which is an electron-hole pair, is generated, and as the exciton separates, the electron moves to an n layer, the hole moves to a p layer, and thus photovoltaic power is generated at a p-n junction.

In general, since the maximum voltage generated by a single unit solar cell is only about 0.5 V, multiple solar cells need to be connected in series to be used. A module formed by connecting multiple unit solar cells in this way is called a solar cell module.

A tabbing process is a process of forming a single solar cell module by arranging wires on a plurality of solar cells and electrically connecting the plurality of solar cells.

The background technology of the present disclosure is disclosed in Korean Patent Registration No. 10-1058399 (registered on August 16, 2011, titled "Tabber-stringer and tabbing-stringing method).

### SUMMARY OF THE INVENTION

The present disclosure is directed to providing a bending device and a tabbing apparatus including the same, by which wires are processed so that solar cells can be connected in series in a tabbing process.

According to an aspect of the present disclosure, there is provided a bending device including a stage on which a solar cell having a first surface and a second surface spaced apart from each other in a first direction is seated, and a bending unit spaced apart from the stage and configured to press a wire disposed on the first surface in the first direction.

The wire may include a first portion disposed to face the first surface, and a second portion extending from the first portion in a second direction intersecting the first direction and protruding outward from the first surface, and the bending unit may press the second portion.

The bending unit may include a bending driving unit configured to generate a driving force, a bending body connected to the bending driving unit and configured to receive the driving force from the bending driving unit and reciprocate in a direction parallel to the first direction, and a bending member connected to the bending body and configured to press the second portion in the first direction in conjunction with movement of the bending body.

The bending member may include a first bending rod extending from the bending body in the first direction and a first groove which extends from an end portion of the first bending rod in a direction opposite to the first direction and into which the second portion is inserted.

A width of the first groove may increase in the first direction.

The first groove may pass through both surfaces of the first bending rod intersecting the second direction.

The bending member may further include a second bending rod extending from the bending body in the first direction and spaced apart from the first bending rod and a second groove which extends from an end portion of the second bending rod in the direction opposite to the first direction and into which the second portion is inserted.

The first bending rod and the second bending rod may be spaced apart from each other in the second direction.

The second bending rod and the first bending rod may be sequentially arranged in the second direction.

A width of the second groove may increase in the first direction.

The second bending rod may be connected to the bending body to be movable in the direction parallel to the first direction.

The second bending rod and the first bending rod may sequentially come into contact with the second portion as the bending body moves in the first direction.

The bending member may further include an elastic member disposed between the bending body and the second bending rod.

The stage may include a stage main body, a support block extending from the stage main body to be in contact with the second surface, and a guide block extending from the support block and configured to guide the movement of the second portion bent in the first direction.

The guide block may include a guide body extending from the support block in the second direction and a guide groove which is disposed inside the guide body and into which the second portion bent in the first direction is inserted.

The stage may be provided as a plurality of stages arranged in the second direction, and each of the stages supports a different solar cell.

The stage may be movable in a direction parallel to the second direction.

The stage may further include an insertion hole formed to be concavely recessed inward of the stage main body and disposed to face the guide block.

As a distance between a pair of neighboring stages decreases, the guide block of one of the pair of neighboring stages may be inserted into the insertion hole of the other.

A tabbing apparatus according to the present disclosure includes a supply device configured to supply a solar cell and a wire, a transfer device configured to seat the wire on the solar cell, a bending device configured to perform bending of the wire seated on the solar cell, and a bonding device configured to bond the solar cell and the wire, wherein the bending device includes a stage on which a solar cell having a first surface and a second surface spaced apart from each other in a first direction is seated, and a bending unit spaced apart from the stage and configured to press the wire disposed on the first surface in the first direction.

### BRIEF DESCRIPTION OF THE DRAWINGS

The above and other objects, features and advantages of the present disclosure will become more apparent to those of ordinary skill in the art by describing exemplary embodiments thereof in detail with reference to the accompanying drawings, in which:
FIG. 1 is a schematic plan view illustrating a configuration of a tabbing apparatus according to one embodiment of the present disclosure;
FIG. 2 is a schematic front view illustrating the configuration of the tabbing apparatus according to one embodiment of the present disclosure;
FIG. 3 is a schematic perspective view illustrating a configuration of a transfer device according to one embodiment of the present disclosure;
FIG. 4 is a schematic side view illustrating the configuration of the transfer device according to one embodiment of the present disclosure;
FIG. 5 is a schematic front view illustrating the configuration of the transfer device according to one embodiment of the present disclosure;
FIG. 6 is a schematic perspective view illustrating a configuration of a transfer unit according to one embodiment of the present disclosure;
FIG. 7 is a schematic front view illustrating the configuration of the transfer unit according to one embodiment of the present disclosure;
FIG. 8 is a schematic side view illustrating the configuration of the transfer unit according to one embodiment of the present disclosure;
FIG. 9 is a schematic view illustrating a configuration of a gripper according to one embodiment of the present disclosure;
FIG. 10 is a schematic perspective view illustrating a configuration of a stage according to one embodiment of the present disclosure;
FIG. 11 is a schematic side view illustrating the configuration of the stage according to one embodiment of the present disclosure;
FIG. 12 is a schematic plan view illustrating the configuration of the stage according to one embodiment of the present disclosure;
FIG. 13 is a schematic enlarged view illustrating a configuration of a bending unit according to one embodiment of the present disclosure;
FIG. 14 is a schematic bottom perspective view illustrating a bending member according to one embodiment of the present disclosure;
FIG. 15 is a schematic front view illustrating the configuration of the bending member according to one embodiment of the present disclosure;
FIGS. 16 to 21 are schematic views illustrating an operation process of the transfer device according to one embodiment of the present disclosure;
FIGS. 22 to 25 are schematic views showing an operation process of the bending device according to one embodiment of the present disclosure;
FIG. 26 is a schematic side view illustrating a configuration of a bending member according to another embodiment of the present disclosure;
FIG. 27 is a schematic bottom perspective view illustrating the bending member according to another embodiment of the present disclosure;
FIG. 28 is a schematic cross-sectional view illustrating the configuration of the bending member according to another embodiment of the present disclosure;
FIG. 29 is a schematic front view illustrating the configuration of the bending member according to another embodiment of the present disclosure; and
FIGS. 30 to 33 are schematic views illustrating an operation process of a bending device according to another embodiment of the present disclosure.

### DETAILED DESCRIPTION OF EXEMPLARY EMBODIMENTS

Hereinafter, embodiments of the present disclosure will be described, in detail, with reference to the accompanying drawings. Prior to this, terms or words used in this specification and claims should not be interpreted as limited to their usual or dictionary meanings and should be interpreted as meanings and concepts that conform to the technical idea of the present disclosure based on the principle that the inventor can appropriately define the concepts of the terms in order to describe his or her own invention in the best way. The embodiments described in this specification and the configurations shown in the drawings are only some embodiments of the present disclosure and do not represent all of the technical ideas of the present disclosure. Accordingly, it should be understood that there may be various equivalents and modifications that can replace them at the time of filing this application. In addition, when used in the present specification, "comprise" and "include" and/or "comprising" and "including" specify the presence of the stated shapes, numbers, steps, operations, members, elements, and/or groups thereof and do not preclude the presence or addition of one or more other shapes, numbers, operations, members, elements, and/or groups thereof. In addition, when describing embodiments of the present disclosure, "may" and "may be" may include "one or more embodiments of the present disclosure."

In addition, to facilitate understanding of the invention, the accompanying drawings are not drawn to scale, and the dimensions of some components may be shown in an exaggerated manner. In addition, the same reference numbers may denote the same components in different embodiments.

When two objects of comparison are "the same", it means that they are "substantially the same." Accordingly, "substantially the same" may include a deviation that is considered low in the art, for example, a deviation within 5%. In addition, uniformity of a parameter over a given region may mean uniformity from the viewpoint of an average.

Although "first," "second," etc. are used to describe various components, these components are not limited by these terms. These terms are used only to distinguish one component from another, and unless otherwise stated, it is obvious that a first component may be a second component.

Throughout the specification, unless otherwise stated, each element may be singular or plural.

When any component is disposed "above (or below)" or "on (or under)" a component, it may mean not only that any component is disposed in contact with an upper surface (or lower surface) of the component, but also that other components may be interposed between the component and any component disposed on (or under) the component.

In addition, when a certain component is described as being "connected," "coupled," or "joined" to another component, the components may be directly connected or joined, but it should be understood that another component may be "interposed" between the components, or the components may be "connected," "coupled," or "joined" through the other component. In addition, when a first component is described as being "electrically coupled to" a second component, this includes not only a case in which the first component is "directly coupled" to the second component, but also a case in which the first component is "coupled" to the second component with a third component interposed therebetween.

When referring to "A and/or B" throughout the specification, this means A, B, or A and B unless otherwise specified. In other words, the term "and/or" includes all or any combination of the plurality of listed items. When referring to "C to D," this means C or more and D or less unless otherwise specified.

When phrases such as "at least one of A, B, and C, "at least one of A, B, or C," "at least one selected from a group of A, B, and C," and "at least one selected from among A, B, and C" are used to designate a list of elements A, B, and C, the phrase may refer to any and all suitable combinations thereof.

The term "use" may be considered synonymous with the term "utilize." As used herein, the terms "substantially," "about," and similar terms are used as terms of approximation and not as terms of degree and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be named a second element, component, region, layer, or section without departing from the teachings of example embodiments.

Spatially relative terms, such as "beneath," "below," "lower," "above," "upper," and the like, may be used herein for ease of description to describe a relationship of one element or feature to (an)other element(s) or feature(s) as illustrated in the drawings. It will be understood that the spatially relative terms are intended to encompass different orientations of the device in use or operation in addition to the orientations depicted in the drawings. For example, if a device in the drawings is turned over, elements described as "below" or "beneath" other elements would then be understood to be "above" or "over" the other elements. Thus, the term "below" may encompass both an orientation of above and below.

The terminology used herein is intended to describe embodiments of the present disclosure and is not intended to limit the present disclosure.

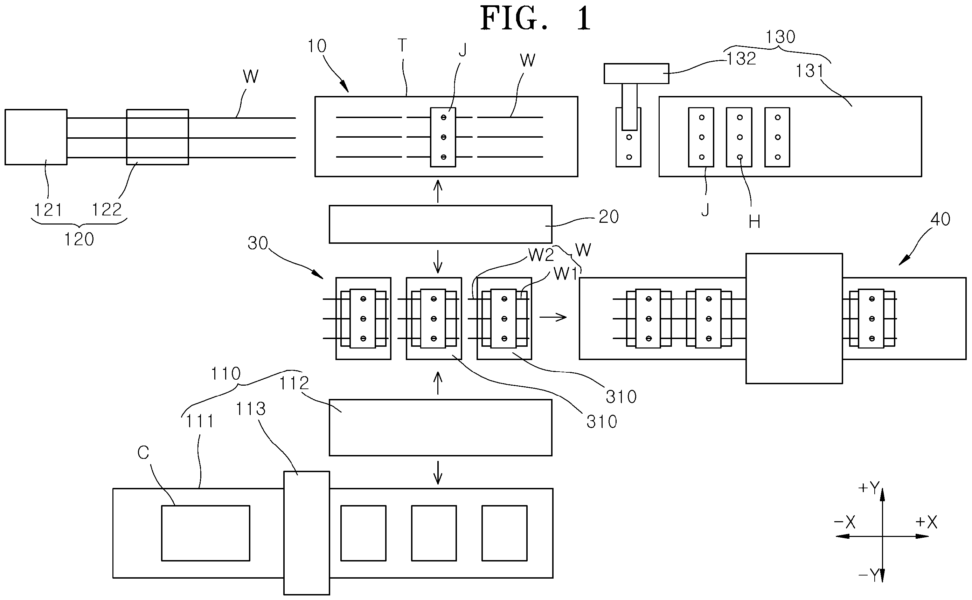

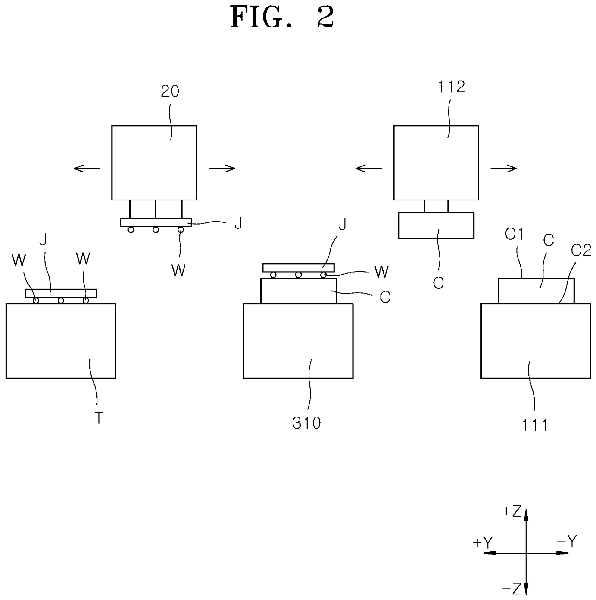

FIG. 1 is a schematic plan view illustrating a configuration of a tabbing apparatus according to one embodiment of the present disclosure, and FIG. 2 is a schematic front view illustrating the configuration of the tabbing apparatus according to one embodiment of the present disclosure.

As will be described below, a first direction may be a -Z-axis direction based on FIG. 2, a second direction may be a -X-axis direction based on FIG. 1, and a third direction may be a +Y-axis direction based on FIG. 1.

A tabbing apparatus is an apparatus for connecting solar cells C to wires W to form a solar cell module.

Referring to FIGS. 1 and 2, the tabbing apparatus according to the present embodiment includes a supply device 10, a transfer device 20, a bending device 30, and a bonding device 40.

The supply device 10 may include a cell supply device 110, a wire supply device 120, and a jig supply device 130.

The cell supply device 110 may supply the solar cell C.

The solar cell C has a semiconductor junction area having a p-n junction surface, and when energy with a predetermined magnitude or more is radiated, an electromotive force may be generated to convert light energy into electrical energy. A material of a semiconductor included in the solar cell C is not particularly limited, and silicon (single crystal, polycrystalline, and amorphous), gallium arsenide, cadmium tellurium, cadmium sulfide, indium phosphide, copper indium gallium selenide (CIGS), an organic dye, or a mixture thereof may be used.

The solar cell C may include a first surface C1 and a second surface C2 opposite to each other. The first surface C1 and the second surface C2 may serve as a positive electrode and a negative electrode of the solar cell C, respectively. The first surface C1 and the second surface C2 may be disposed to be spaced apart from each other in the first direction.

The cell supply device 110 may include a cell supply line 111 and a cell transfer unit 112.

The cell supply line 111 may consecutively supply a plurality of solar cells C. For example, the cell supply line 111 may include various types of supply means, such as a belt conveyor, a chain conveyor, a roller conveyor, a shuttle conveyor, and the like, which may consecutively supply the plurality of solar cells C in one direction.

The cell transfer unit 112 may move the solar cells C supplied from the cell supply line 111 to a stage 310 of the bending device 30. The cell transfer unit 112 may move in a reciprocating or circulating manner between the cell supply line 111 and the stage 310 and transfer the solar cell C supplied from the cell supply line 111 to the stage 310 of the bending device 30. The cell transfer unit 112 may include an adsorption means for adsorbing the solar cell C by vacuum pressure, a gripping means for mechanically gripping the solar cell C, or the like.

The cell transfer unit 112 may simultaneously move a plurality of solar cells C to different stages 310. The number of solar cells C transferred by the cell transfer unit 112 may be designed to vary.

The cell supply device 110 may further include a cell splitting unit 113.

The cell splitting unit 113 may be connected to the cell supply line 111. The cell splitting unit 113 may split the solar cell C supplied by the cell supply line 111 into a size set according to a required size. For example, the cell splitting unit 113 may bisect the solar cell C supplied by the cell supply line 111. The cell splitting unit 113 may include various types of cutting means such as a laser, a water jet, a blade, or the like. The solar cell C moving in one direction from a front end side of the cell supply line 111 may be split by the cell splitting unit 113 and then moved toward a rear end of the cell supply line 111. Thereafter, the solar cell C moved to the rear end side of the cell supply line 111 may be transferred to the stage 310 by the cell transfer unit 112.

FIG. 1 illustrates an example in which the cell supply device 110 includes the cell splitting unit 113, but the cell supply device 110 is not limited thereto and may be formed not to include the cell splitting unit 113.

The wire supply device 120 may supply a wire W.

The wire W may serve as a conductor for electrically connecting a plurality of solar cells C. The wire W may electrically connect a pair of solar cells C disposed adjacent to each other in a solar cell module.

For example, the wire W may include a first portion W1 connected to the first surface C1 of one of neighboring solar cells C, and a second portion W2 connected to the second surface C2 of the other.

The wire W may be electrically connected to the solar cell C through a soldering process. Alternatively, the wire W may be electrically connected to the solar cell C through an electrically conductive adhesive (ECA) curing process.

The wire supply device 120 according to the present embodiment may include a wire supply line 121 and a wire cutting unit 122.

The wire supply line 121 may supply the wire W to the wire cutting unit 122 to be described below. For example, the wire supply line 121 may include various types of supply units for drawing out the wire W wound around a roller (not illustrated) and transferring the wire W to the wire cutting unit 122.

The wire supply line 121 may supply a plurality of wires W in parallel. For example, the wire supply line 121 may supply the wire W so that the plurality of wires W are arranged at set intervals in a direction perpendicular to a longitudinal direction of one wire W.

The wire cutting unit 122 may cut the wire W supplied from the wire supply line 121. The wire cutting unit 122 may cut the wire W supplied from the wire supply line 121 into a unit length. The unit length of the wire W cut by the wire cutting unit 122 may be greater than the length of one solar cell C and smaller than the total length of a pair of solar cells C. Here, the length of the solar cell C may be a length parallel to the second direction.

The wire cutting unit 122 may cut one wire W supplied from the wire supply line 121 into the same number as the number of solar cells C seated on the stage 310.

The wire cutting unit 122 may simultaneously cut the plurality of wires W supplied in parallel by the wire supply line 121.

The wire W cut by the wire cutting unit 122 may be transferred to a wire-jig table T.

The wire-jig table T according to the present embodiment may be disposed to face the cell supply line 111. For example, the cell supply line 111 and the wire-jig table T may be spaced apart from each other in the third direction.

The wire W cut by the wire cutting unit 122 may be transferred to the wire-jig table T by a separate transfer unit such as a conveyor, an adsorber, or the like and transferred to the wire-jig table T by the independent movement of the wire-jig table T, the wire supply line 121, and the wire cutting unit 122.

The plurality of wires W may be arranged in a direction parallel to the second direction on the wire-jig table T. For example, the wire W may be disposed in a form in which the second portion W2 extends from the first portion W1 in the second direction. The number of wires W arranged in the direction parallel to the second direction on the wire-jig table T may be equal to the number of solar cells C seated on the stage 310.

When the wire supply line 121 supplies the wires W in parallel, the plurality of wires W may be arranged in the direction parallel to the second direction and the third direction on the wire-jig table T. The number of wires W arranged in a direction parallel to the third direction on the wire-jig table T may be designed to vary depending on the width or the like of the solar cell C parallel to the third direction.

When the solar cell C and the wire W are bonded through a soldering process, the wire supply device 120 may further include a flux application device (not illustrated) for applying a flux on a surface of the wire W.

When the solar cell C and the wire W are bonded through an ECA curing process, the cell supply device 110 may further include an ECA application device (not illustrated) for applying an ECA on the first surface C1 and the second surface C2 of the solar cell C.

The jig supply device 130 may supply a jig J.

The jig J may serve as a component for fixing the wire W to prevent the wire W from being lifted or separated from a specified position when the solar cell C and the wire W are bonded by the bonding device 40 to be described below. The jig J may have a plurality of through holes H formed to vertically pass through both surfaces of the jig J.

The jig supply device 130 may include a jig supply line 131 and a jig transfer unit 132.

The jig supply line 131 may consecutively supply a plurality of jigs J. For example, the jig supply line 131 may include various types of supply means, such as a belt conveyor, a chain conveyor, a roller conveyor, a shuttle conveyor, and the like, which may consecutively supply the plurality of jigs J in one direction. The jig supply line 131 may recover and supply the jig J discharged from the bonding device 50.

The jig transfer unit 132 may transfer the jig J supplied from the jig supply line 131 to the wire-jig table T. For example, the jig transfer unit 132 may be installed to reciprocate between the jig supply line 131 and the wire-jig table T. The jig transfer unit 132 may include an adsorption means for adsorbing the jig J by vacuum pressure, a gripping means for mechanically gripping the jig J, or the like. The jig transfer unit 132 may seat the jig J on the wire W disposed on the wire-jig table T. As the jig J is seated on the wire W, the through hole H formed in the jig J may be disposed to face the wire W.

The transfer device 20 may seat the wire W and the jig J on the solar cell C. That is, the transfer device 20 may serve as a component for simultaneously moving the wire W and the jig J which are seated on the wire-jig table T to the solar cell C seated on the stage 310. Accordingly, the transfer device 20 can shorten the overall process time and reduce the size of the equipment compared to a case in which the wire W and the jig J are transferred by separate devices.

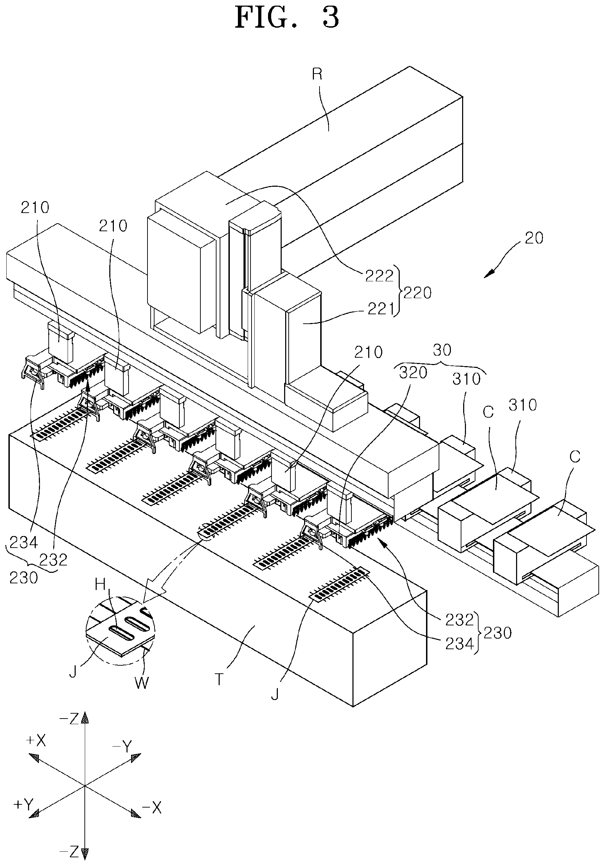

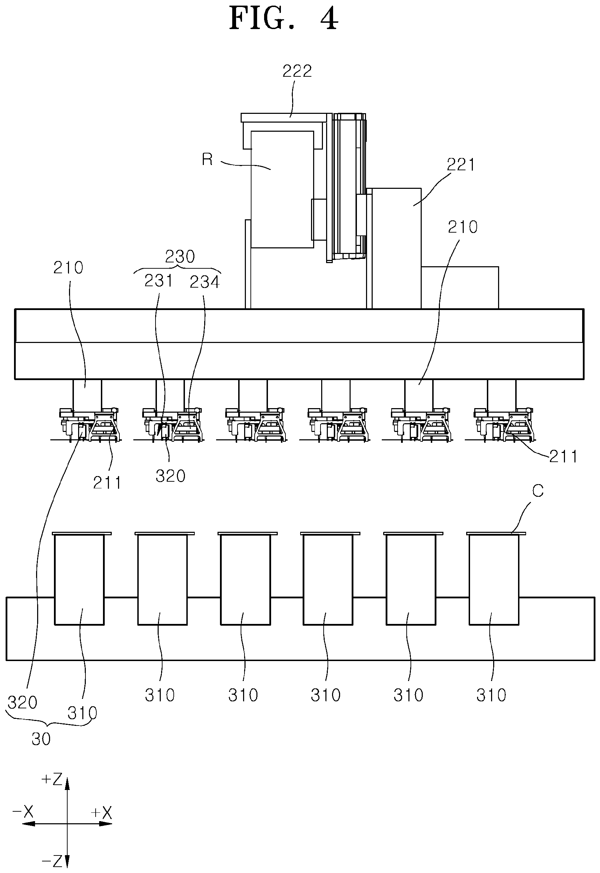

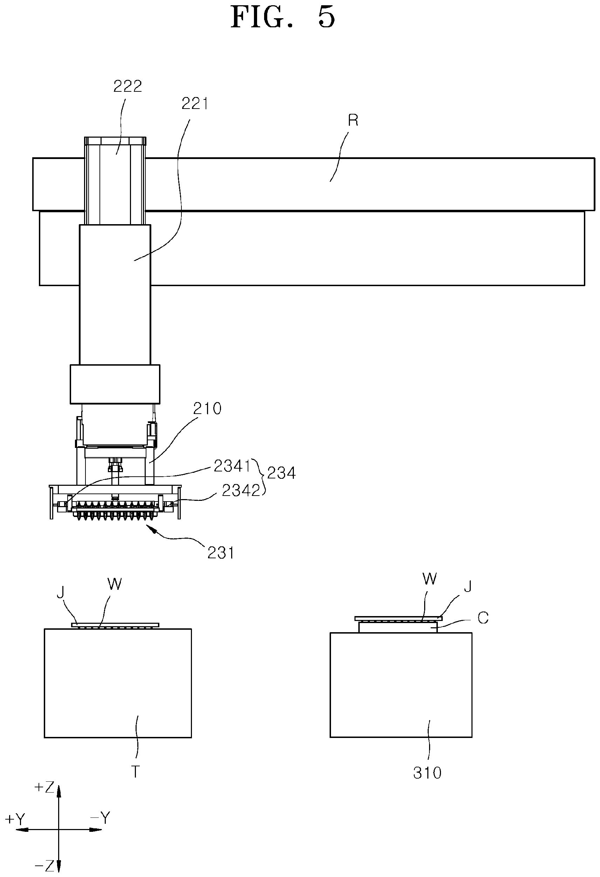

FIG. 3 is a schematic perspective view illustrating a configuration of a transfer device according to one embodiment of the present disclosure, FIG. 4 is a schematic side view illustrating the configuration of the transfer device according to one embodiment of the present disclosure, and FIG. 5 is a schematic front view illustrating the configuration of the transfer device according to one embodiment of the present disclosure.

Referring to FIGS. 1 to 5, the transfer device 20 according to the present embodiment may include a transfer main body 210, a position adjustment unit 220, and a transfer unit 230.

The transfer main body 210 may be installed to be movable to a position above the first surface C1 of the solar cell C. More specifically, a position of the transfer main body 210 may be freely changed in a space above the first surface C1 of the solar cell C by the position adjustment unit 220 to be described below. A specific shape of the transfer main body 210 is not limited to the shape illustrated in FIGS. 3 to 5 and may be designed to have various shapes which can be connected to the position adjustment unit 220 to support the transfer unit 230.

A support frame 211 may be formed on the transfer main body 210. The support frame 211 may serve as a component which comes into contact with the wire-jig table T or the stage 310 to support the transfer main body 210 when the transfer main body 210 moves toward the wire-jig table T or the stage 310.

The support frame 211 according to the present embodiment may be provided as a pair of support frames. The pair of support frames 211 may be disposed symmetrically at both sides of the transfer main body 210. For example, the pair of support frames 211 may be disposed to be spaced apart from each other in the third direction with the transfer main body 210 interposed therebetween. A specific shape of the support frame 211 is not limited to the shape illustrated in FIGS. 3 to 5, and various design changes are possible within the technical concept of the shape which can come into contact with the wire-jig table T or the stage 310 when the transfer main body 210 moves toward the wire-jig table T or the stage 310.

The position adjustment unit 220 may support the transfer main body 210 and adjust the position of the transfer main body 210. The position adjustment unit 220 may be provided to adjust the position of the transfer main body 210 in multiple directions.

The position adjustment unit 220 may include a first position adjustment unit 221 and a second position adjustment unit 222.

The first position adjustment unit 221 may be connected to the transfer main body 210 and may move the transfer main body 210 in a direction parallel to the first direction. That is, the first position adjustment unit 221 may serve as a component for increasing or decreasing a vertical distance between the transfer main body 210 and the solar cell C.

The first position adjustment unit 221 according to the present embodiment may reciprocate in the direction parallel to the first direction by a driving force generated from a motor, a cylinder, or the like. A specific shape of the first position adjustment unit 221 is not limited to the shape illustrated in FIGS. 3 to 5 and various design changes are possible within the technical concept of the shape which can be connected to the transfer main body 210 to move the transfer main body 210 in the direction parallel to the first direction.

The second position adjustment unit 222 may be connected to the first position adjustment unit 221 to move the transfer main body 210 in a direction intersecting the first direction. That is, the second position adjustment unit 222 may serve as a component for increasing or decreasing a horizontal distance between the transfer main body 210 and the solar cell C.

The second position adjustment unit 222 according to the present embodiment may be movably connected to a transfer rail R disposed parallel to the third direction. The second position adjustment unit 222 may reciprocate along the transfer rail R in a direction parallel to the third direction by a driving force generated from a motor, cylinder, or the like. Accordingly, the second position adjustment unit 222 may reciprocate the transfer main body 210 between the wire-jig table T and the stage 310. A specific shape of the second position adjustment unit 222 is not limited to the shape illustrated in FIGS. 3 to 5, and various design changes are possible within the technical concept of the shape which can be connected to the first position adjustment unit 221 to move the transfer main body 210 in a direction different from the first direction.

The transfer main body 210 may be connected to the position adjustment unit 220 to be movable in a direction parallel to the longitudinal direction of the wire W. That is, the transfer main body 210 may be connected to the first position adjustment unit 221 to reciprocate in a direction parallel to the second direction. The transfer main body 210 may receive a driving force generated from a motor, cylinder, or the like and reciprocate in the direction parallel to the second direction.

Although an example in which the transfer main body 210 is connected to the first position adjustment unit 221 to be movable in the direction parallel to the second direction and the second position adjustment unit 222 moves in the direction parallel to the third direction has been described above, the present disclosure is not limited thereto, and the transfer main body 210 may be fixed to the first position adjustment unit 221, and the second position adjustment unit 222 may be formed to be simultaneously movable in directions parallel to the second and third directions.

The transfer main body 210 may be provided as a plurality of transfer main bodies. The plurality of transfer main bodies 210 may be arranged at set intervals in the second direction on the position adjustment unit 220, more specifically, the first position adjustment unit 221. The number of transfer main bodies 210 may be formed to correspond to the number of stages 310. Accordingly, when the first position adjustment unit 221 moves to a position above the stage 310, the plurality of transfer main bodies 210 may be disposed to face each stage 310 independently.

Each transfer main body 210 may move independently in the direction parallel to the second direction. Accordingly, the distance between neighboring transfer main bodies 210 may be freely adjusted in response to the length of the wire W, the size of the jig J, and the like.

The transfer unit 230 may move along with the transfer main body 210 and transfer the wire W and the jig J.

The transfer unit 230 may be provided as a plurality of transfer units. Each transfer unit 230 may be separately connected to a different transfer main body 210. The plurality of transfer units 230 may be arranged in the longitudinal direction of the wire W, that is, the direction parallel to the second direction. Each transfer unit 230 may transfer the plurality of wires W and jigs J disposed in the second direction on the wire-jig table T onto the first surface C1 of a different solar cell C.

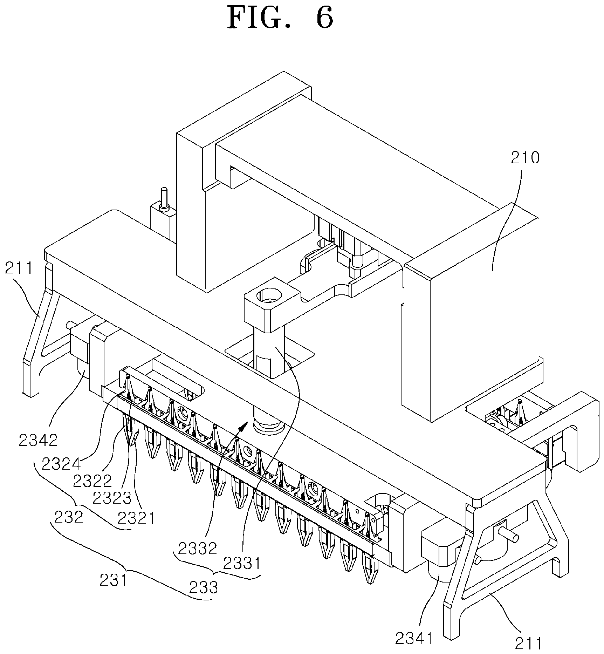

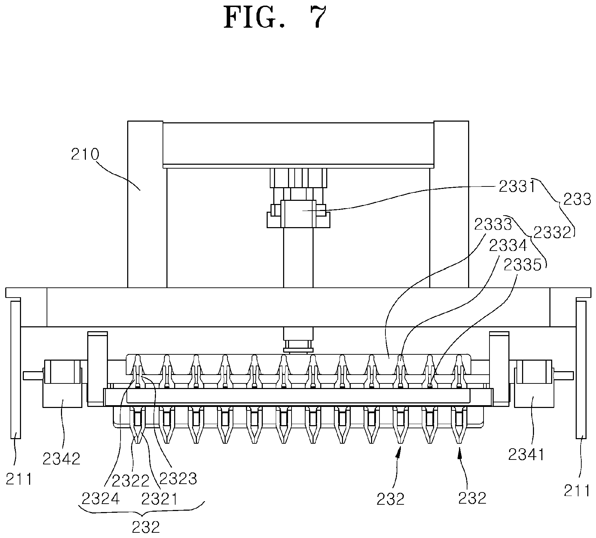

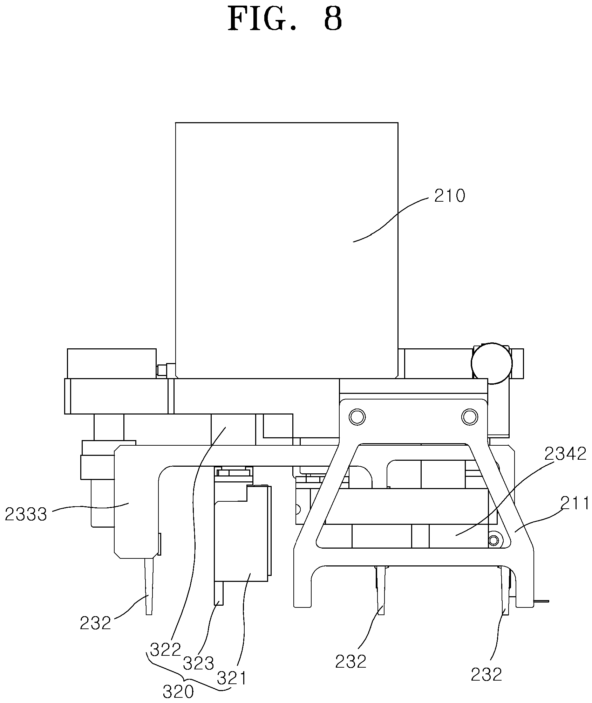

FIG. 6 is a schematic perspective view illustrating a configuration of a transfer unit according to one embodiment of the present disclosure, FIG. 7 is a schematic front view illustrating the configuration of the transfer unit according to one embodiment of the present disclosure, and FIG. 8 is a schematic side view illustrating the configuration of the transfer unit according to one embodiment of the present disclosure.

Referring to FIGS. 1 to 8, the transfer unit 230 according to the present embodiment may include a first transfer member 231 and a second transfer member 234.

The first transfer member 231 may form an exterior of one side of the transfer unit 230 and transfer the wire W.

The first transfer member 231 may include a gripper 232 and a gripper driving unit 233.

The gripper 232 may be connected to the transfer main body 210 and may grip the wire W by a mechanical force.

For one transfer main body 210, a plurality of grippers 232 may be provided.

The plurality of grippers 232 may be arranged in the longitudinal direction of the wire W, that is, the direction parallel to the second direction. For example, for one transfer main body 210, the grippers 232 may be arranged in three rows in the second direction. The plurality of grippers 232 arranged in the second direction may individually grip different parts of the wire W, which are spaced apart from each other in the longitudinal direction of the wire W. Accordingly, the gripper 232 can prevent the wire W from being bent or sagging due to gravity or the like when the wire W is transferred. Distances between neighboring grippers 232 in the second direction may be the same or may be formed differently.

The plurality of grippers 232 may be arranged in a direction intersecting the longitudinal direction of the wire W. For example, for one transfer main body 210, the plurality of grippers 232 may be arranged in the direction parallel to the third direction. Accordingly, the gripper 232 may simultaneously transfer a plurality of wires disposed parallel to each other in the third direction to a position above the wire-jig table.

As the transfer main body 210 moves to a position above the wire-jig table T, the gripper 232 may be disposed to face the through hole H formed in the jig J. As the transfer main body 210 moves toward the wire W on the wire-jig table T, the gripper 232 may be inserted into the through hole H and may protrude outward from the jig J. Accordingly, the gripper 232 may smoothly grip the wire W disposed under the jig J without interference with the jig J on the wire-jig table T.

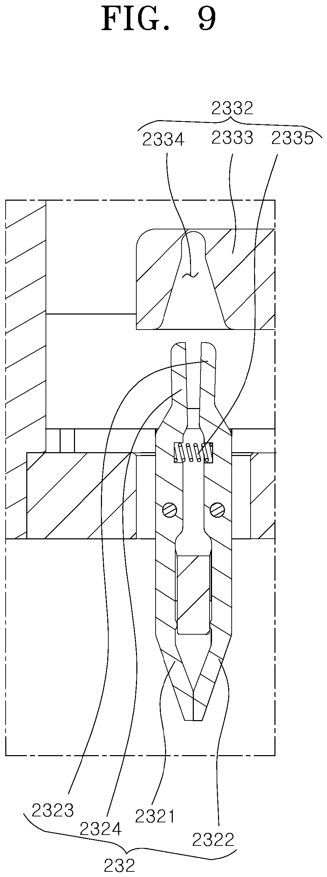

FIG. 9 is a schematic view illustrating a configuration of a gripper according to one embodiment of the present disclosure.

Referring to FIGS. 1 to 9, the gripper 232 may include a first gripper 2321, a second gripper 2322, a first extension 2323, and a second extension 2324.

The first gripper 2321 may be rotatably connected to the transfer main body 210. The first gripper 2321 according to the present embodiment may be formed to have a substantially rod shape. A central portion of the first gripper 2321 may be rotatably connected to the transfer main body 210 via a pin, a hinge, or the like. For example, the central portion of the first gripper 2321 may be connected to the transfer main body 210 so as to be rotatable around the longitudinal direction of the wire W, that is, the direction parallel to the second direction. An end portion of the first gripper 2321 may protrude outward from the transfer main body 210. When the transfer main body 210 moves to a position above the wire-jig table T, the end portion of the first gripper 2321 may be disposed to face the wire W in the first direction.

The second gripper 2322 may be spaced apart from the first gripper 2321 and rotatably connected to the transfer main body 210.

The second gripper 2322 according to the present embodiment may be disposed to face the first gripper 2321 in a width direction of the wire W, that is, the third direction. The second gripper 2322 may be formed to have a substantially rod shape. A central portion of the second gripper 2322 may be rotatably connected to the transfer main body 210 via a pin, a hinge, or the like. For example, the central portion of the second gripper 2322 may be connected to the transfer main body 210 so as to be rotatable around the longitudinal direction of the wire W, that is, the direction parallel to the second direction. An end portion of the second gripper 2322 may protrude outward from the transfer main body 210. When the transfer main body 210 moves to a position above the wire-jig table T, the end portion of the second gripper 2322 may be disposed to face the wire W in the first direction.

The first gripper 2321 and the second gripper 2322 may rotate in opposite directions to grip the wire W or release the gripping of the wire W. For example, when the first gripper 2321 rotates counterclockwise and the second gripper 2322 rotates clockwise based on FIG. 9, the distance between the end portions of the first gripper 2321 and the second gripper 2322 may be decreased, and the first gripper 2321 and the second gripper 2322 may grip the wire W by pressing both sides of the wire W.

Conversely, when the first gripper 2321 rotates clockwise and the second gripper 2322 rotates counterclockwise based on FIG. 9, the distance between the end portions of the first gripper 2321 and the second gripper 2322 may be increased, and the first gripper 2321 and the second gripper 2322 may be spaced apart from the wire W and release the gripping of the wire W.

The first extension 2323 and the second extension 2324 may extend from the first gripper 2321 and the second gripper 2322, respectively.

The first extension 2323 and the second extension 2324 according to the present embodiment may have a rod shape extending from the central portions of the first gripper 2321 and the second gripper 2322 in a direction away from the end portions of the first gripper 2321 and the second gripper 2322. The first extension 2323 and the second extension 2324 may be disposed to face each other in the third direction.

The first extension 2323 and the second extension 2324 may rotate in opposite directions to adjust the distance between the first gripper 2321 and the second gripper 2322. The rotational directions of the first extension 2323 and the second extension 2324 may be the same as the rotational directions of the first gripper 2321 and the second gripper 2322, respectively. The distance between the first gripper 2321 and the second gripper 2322 may increase or decrease in inverse proportion to a change in distance between the first extension 2323 and the second extension 2324.

For example, when the first extension 2323 is rotated counterclockwise and the second extension 2324 is rotated clockwise based on FIG. 9, the distance between end portions of the first extension 2323 and the second extension 2324 may increase, and the distance between the end portions of the first gripper 2321 and the second gripper 2322 may decrease.

Conversely, when the first extension 2323 is rotated clockwise and the second extension 2324 is rotated counterclockwise based on FIG. 9, the distance between the end portions of the first extension 2323 and the second extension 2324 may decrease, and the distance between the end portion of the first gripper 2321 and the second gripper 2322 may increase.

The gripper driving unit 233 may be connected to the gripper 232 and may control the gripping operation of the gripper 232. That is, the gripper driving unit 233 may serve as a component for automatically adjusting the distance between the end portions of the first gripper 2321 and the second gripper 2322 by rotating the first extension 2323 and the second extension 2324 by its own driving force.

The gripper driving unit 233 may include an actuator 2331 and an adjustment member 2332.

The actuator 2331 may generate a driving force for operating the adjustment member 2332 to be described below. The actuator 2331 according to the present embodiment may be, for example, various types of power devices for generating a driving force by externally applied power or hydraulic pressure, such as a motor, a hydraulic cylinder, and the like. The actuator 2331 may be fixed to the transfer main body 210 by various types of coupling methods, such as welding, bolting, and the like.

The adjustment member 2332 may rotate the first extension 2323 and the second extension 2324 in opposite directions in conjunction with the driving force generated by the actuator 2331.

The adjustment member 2332 may include an adjustment block 2333, an adjustment groove 2334, and a restoring member 2335.

The adjustment block 2333 may be movably installed on the transfer main body 210. The adjustment block 2333 may be connected to the actuator 2331 and moved by receiving the driving force from the actuator 2331.

The adjustment block 2333 according to the present embodiment may be disposed to face the end portions of the first extension 2323 and the second extension 2324 in the first direction. The adjustment block 2333 may be installed on the transfer main body 210 to reciprocate in the direction parallel to the first direction.

The adjustment block 2333 may be provided as a plurality of adjustment blocks. The plurality of adjustment blocks 2333 installed on one transfer main body 210 may be arranged in the second direction. Each adjustment block 2333 may be individually disposed to face a different gripper 232 arranged in the second direction.

The adjustment groove 2334 may be disposed inside the adjustment block 2333. The adjustment groove 2334 may serve as a component for decreasing the distance between the first extension 2323 and the second extension 2324 by the linear movement of the adjustment block 2333.

The adjustment groove 2334 according to the present embodiment may have a groove shape which is concavely recessed from one surface of the adjustment block 2333, which faces the end portions of the first extension 2323 and the second extension 2324, inward of the adjustment block 2333. A longitudinal direction of the adjustment groove 2334 may be disposed parallel to the first direction.

As the adjustment block 2333 moves in the first direction, the end portions of the first extension 2323 and the second extension 2324 may be inserted into the adjustment groove 2334.

The width of the adjustment groove 2334 may increase from the adjustment block 2333 toward the gripper 232. That is, the width of the adjustment groove 2334 may increase in the first direction. Here, the width of the adjustment groove 2334 may be a width parallel to the third direction.

The width of one end portion of the adjustment groove 2334 located at a surface of the adjustment block 2333 may be sized so that the end portions of the first extension 2323 and the second extension 2324, which are spaced apart from each other, may both be smoothly inserted when the adjustment block 2333 moves downward.

The width of the other end portion of the adjustment groove 2334 located inside the adjustment block 2333 may be sized so that the end portions of the first extension 2323 and the second extension 2324 may come into contact with each other.

Accordingly, when the adjustment block 2333 moves in the first direction, the distance between the first extension 2323 and the second extension 2324 is gradually decreased as the first extension 2323 and the second extension 2324 come into contact with an inner surface of the adjustment groove 2334, and the first extension 2323 and the second extension 2324 may increase the distance between the first gripper 2321 and the second gripper 2322.

As the adjustment block 2333 moves in a direction opposite to the first direction, the end portions of the first extension 2323 and the second extension 2324 may be separated from the inside of the adjustment groove 2334.

The adjustment groove 2334 may be provided as a plurality of adjustment grooves. The plurality of adjustment grooves 2334 may be individually formed in different adjustment blocks 2333. The plurality of adjustment grooves 2334 formed in one adjustment block 2333 may be arranged in the third direction. Each adjustment groove 2334 may be individually disposed to face the first extension 2323 and the second extension 2324 of a different gripper 232.

The restoring member 2335 may serve as a component for increasing the distance between the first extension 2323 and the second extension 2324 by the linear movement of the adjustment block 2333.

The restoring member 2335 according to the present embodiment may be disposed between the first extension 2323 and the second extension 2324. The restoring member 2335 may have both end portions connected to inner surfaces of the first extension 2323 and the second extension 2324, respectively. A longitudinal direction of the restoring member 2335 may be disposed parallel to the third direction. The restoring member 2335 may be provided to be elastically deformable.

For example, the restoring member 2335 may be formed to have the shape of a coil spring which can be compressed or stretched in the longitudinal direction. The restoring member 2335 may apply an elastic force to the first extension 2323 and the second extension 2324 in a direction which separates the first extension 2323 from the second extension 2324. Accordingly, when the adjustment block 2333 moves in the direction opposite to the first direction, the distance between the first extension 2323 and the second extension 2324 is gradually increased by the elastic force of the restoring member 2335 and the contact with the inner surface of the adjustment groove 2334, and the first extension 2323 and the second extension 2324 may decrease the distance between the first gripper 2321 and the second gripper 2322.

The second transfer member 234 may form an exterior of the other side of the transfer unit 230 and transfer the jig J.

The second transfer member 234 may include a first jig holder 2341 and a second jig holder 2342 which are connected to the transfer main body 210.

The first jig holder 2341 and the second jig holder 2342 according to the present embodiment may transfer the jig J by generating an electromagnetic force to adsorb the jig J or release the jig J.

The first jig holder 2341 and the second jig holder 2342 may be disposed to be spaced apart from each other and may individually adsorb different parts of the jig J.

The first jig holder 2341 and the second jig holder 2342 may be disposed to be spaced apart from each other with the first transfer member 231 interposed therebetween. The first jig holder 2341 and the second jig holder 2342 may be disposed at both sides of the first transfer member 231, respectively. The first jig holder 2341 and the second jig holder 2342 may be spaced apart from each other in a direction intersecting the longitudinal direction of the wire W. For example, the first jig holder 2341 and the second jig holder 2342 may be spaced apart from each other in the third direction with the gripper 232 interposed therebetween. Accordingly, the first jig holder 2341 and the second jig holder 2342 may smoothly adsorb the jig J without interference with the gripper 232.

The first jig holder 2341 and the second jig holder 2342 may protrude from the transfer main body 210 in the first direction. The lengths by which the first jig holder 2341 and the second jig holder 2342 protrude from the transfer main body 210 may be smaller than the length by which the gripper 232 protrudes from the transfer main body 210. That is, an end of the gripper 232 adjacent to the wire W may be located below the bottom surfaces of the first jig holder 2341 and the second jig holder 2342. Accordingly, after the first jig holder 2341 and the second jig holder 2342 come into contact with the jig J, the gripper 232 may protrude outward from the jig J through the through hole H. Accordingly, the first and second transfer members 231 and 234 may simultaneously transfer the jig J disposed on the wire W.

The bending device 30 may serve as a component for performing bending processing on the wire W seated on the solar cell C so that neighboring solar cells C may be connected in series.

The bending device 30 according to the present embodiment may include the stage 310 and a bending unit 320.

The stage 310 may serve as a component for providing a space in which the solar cell C, the wire W, and the jig J which are supplied from the supply device 10 are seated.

The stage 310 may be disposed between the cell supply line 111 and the wire-jig table T. For example, the cell supply line 111, the stage 310, and the wire-jig table T may be disposed sequentially in the third direction.

The stage 310 may receive the solar cell C from the cell transfer unit 112. The solar cell C transferred from the cell transfer unit 112 may be seated on the stage 310. In this case, the second surface C2 of the solar cell C may be disposed to face the stage 310.

After the solar cell C is seated on the stage 310, the stage 310 may receive the wire W and the jig J from the transfer device 20. The wire W and the jig J transferred from the transfer device 20 may be seated on the first surface C1 of the solar cell C. That is, the stage 310, the solar cell C, the wire W, and the jig J may be sequentially stacked in the direction opposite to the first direction.

When the wire W is seated on the solar cell C, the first portion W1 of the wire W may be disposed to face the first surface C1 of the solar cell C, and the second portion W2 of the wire W may be disposed to protrude in the second direction to the outside of the first surface C1 of the solar cell C.

The stage 310 may be provided as a plurality of stages. The plurality of stages 310 may be arranged in the second direction. Each stage 310 may individually support a different solar cell C transferred from the cell transfer unit 112.

The stage 310 may be installed to reciprocate in the direction parallel to the second direction. Accordingly, neighboring stages 310 may move relative to each other in a direction parallel to the second direction and adjust the distance therebetween.

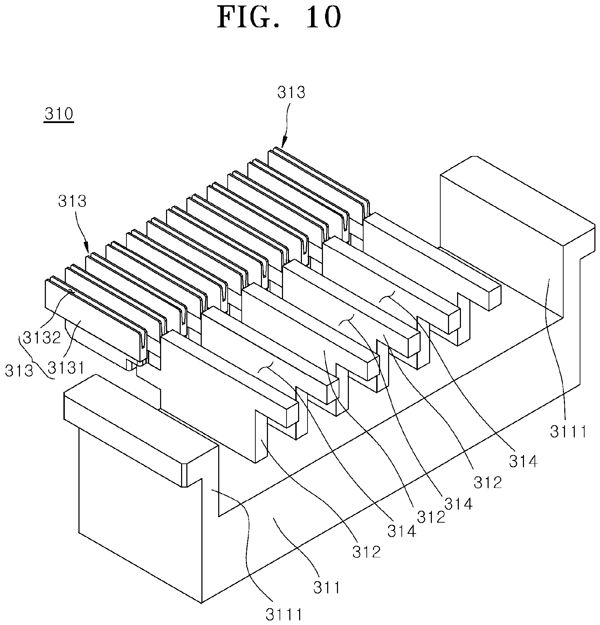

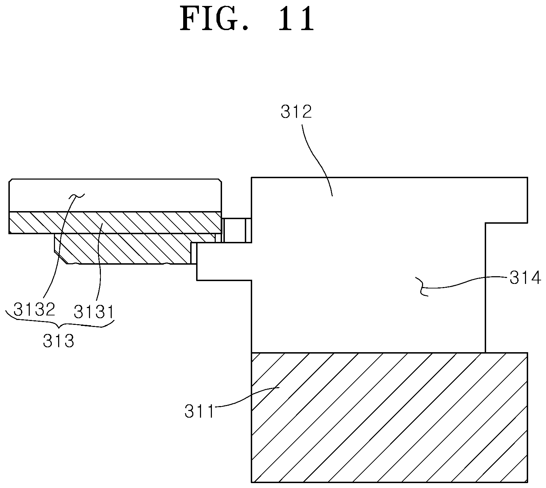

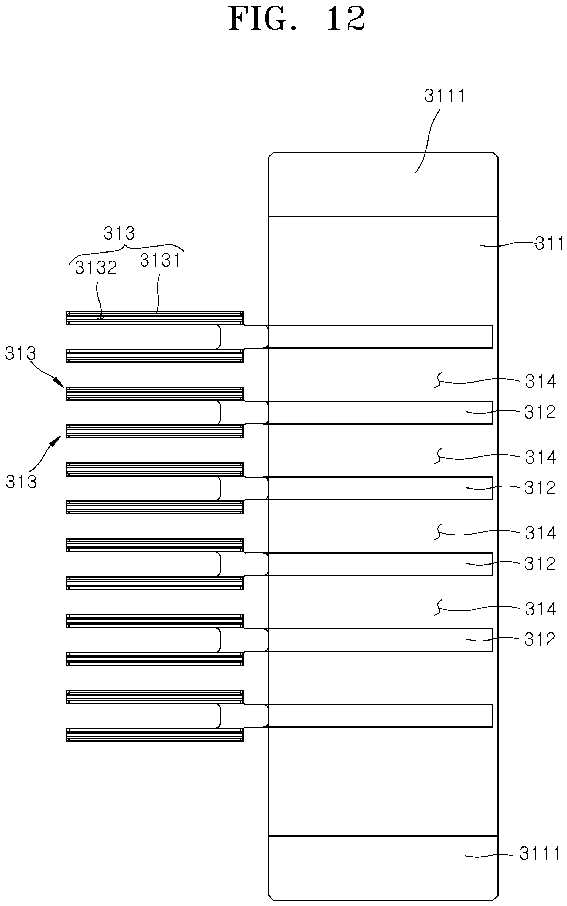

FIG. 10 is a schematic perspective view illustrating a configuration of a stage according to one embodiment of the present disclosure, FIG. 11 is a schematic side view illustrating the configuration of the stage according to one embodiment of the present disclosure, and FIG. 12 is a schematic plan view illustrating the configuration of the stage according to one embodiment of the present disclosure.

Referring to FIGS. 1 to 12, the stage 310 according to the present embodiment may include a stage main body 311, a support block 312, and a guide block 313.

The stage main body 311 may form an approximate exterior of the stage 310 and entirely support the support block 312 and the guide block 313, which will be described below.

The stage main body 311 according to the present embodiment may be formed to have a substantial box shape. The stage main body 311 may be connected to a rail (not illustrated) or the like to reciprocate in the direction parallel to the second direction. The stage main body 311 may receive a driving force from a power device such as a motor, a cylinder, or the like and reciprocate in the direction parallel to the second direction.

A seating portion 3111 on which the support frame 211 of the transfer device 20 is seated may be formed on the stage main body 311. The seating portion 3111 according to the present embodiment may extend from a bottom surface of the stage main body 311 in the direction opposite to the first direction. The seating portion 3111 may be provided as a pair of seating portions. The pair of seating portions 3111 may be disposed at both sides of the stage main body 311, respectively. For example, the pair of seating portions 3111 may be respectively disposed on both end portions of the stage main body 311 spaced apart from each other in the third direction.

The support block 312 extends from the stage main body 311 and supports the solar cell C. The support block 312 according to the present embodiment may extend from the bottom surface of the stage main body 311 in the direction opposite to the first direction. The support block 312 may be disposed on a central portion of the stage main body 311, more specifically, between the pair of seating portions 3111. An end surface of the support block 312 may come into contact with the second surface C2 of the solar cell C being transferred from the cell transfer unit 112 and may support the solar cell C.

The support block 312 may be provided as a plurality of support blocks. The plurality of support blocks 312 may be arranged in the third direction. Neighboring support blocks 312 may be disposed to be spaced a set interval from each other.

The guide block 313 may extend from the support block 312 and guide the movement of the second portion W2 of the wire W, which is bent in the first direction by the bending unit 320 to be described below. Accordingly, the guide block 313 may be formed so that a bending direction of the wire W is consistently formed along a set path.

The guide block 313 according to the present embodiment may include a guide body 3131 and a guide groove 3132.

The guide body 3131 may extend from the support block 312 in the second direction. The guide body 3131 may extend directly from the support block 312 and may be indirectly connected to the support block 312 via a separate bracket or the like. The guide body 3131 may be disposed to face the second portion W2 of the wire W, which protrudes from the first surface C1 in the second direction, in the first direction. The extending length of the guide body 3131 may be designed to vary depending on the length of the second portion W2 of the wire W protruding from the first surface C1 in the second direction.

The height of an end surface of the guide body 3131 may be lower than the height of the end surface of the support block 312. Accordingly, the guide body 3131 may not directly interfere with the second portion W2 of the wire W when the solar cell C is seated on the support block 312.

The guide body 3131 may be provided as a plurality of guide bodies. The plurality of guide bodies 3131 may be arranged in the third direction. A pair of guide bodies 3131 may be formed to extend from one support block 312. For one support block 312, the distance between the pair of guide bodies 3131 parallel to the third direction may be greater than the width of the support block 312 parallel to the third direction.

The guide groove 3132 may be disposed inside the guide body 3131. The guide groove 3132 according to the present embodiment may be formed to have a shape of a groove which is concavely recessed in the first direction from the end surface of the guide body 3131, which faces the second portion W2 of the wire W. The guide groove 3132 may be disposed at a position directly facing the second portion W2 of the wire W in the first direction. A longitudinal direction of the guide groove 3132 may be disposed parallel to the second direction. The guide groove 3132 may pass through both surfaces of the guide body 3131 perpendicular to the second direction. During the operation of the bending unit 320 to be described below, the second portion W2 of the wire W may be deformed in the first direction and inserted into the guide groove 3132.

The width of the guide groove 3132 may be formed to gradually decrease in the first direction. The width of one end portion of the guide groove 3132 located at the end surface of the guide body 3131 may be greater than the diameter of the wire W, and the width of the other end portion of the guide groove 3132 located inside the guide body 3131 may be smaller than the diameter of the wire W. Accordingly, the guide block 313 may be formed so that the second portion W2 is smoothly inserted into the guide groove 3132 at the beginning of deformation of the second portion W2, and when the deformation of the second portion W2 is completed, the second portion W2 is firmly fixed to the inside of the guide groove 3132.

The stage 310 may further include an insertion hole 314.

The insertion hole 314 may be disposed inside the stage main body 311. The insertion hole 314 according to the present embodiment may be, for example, an empty space disposed between neighboring support blocks 312 and between the seating portion 3111 and the support block 312. A longitudinal direction of the insertion hole 314 may be disposed parallel to the second direction. The insertion hole 314 may pass through both surfaces of the stage main body 311 perpendicular to the second direction. The insertion hole 314 may pass through the end surface of the stage main body 311 perpendicular to the first direction.

The insertion hole 314 may be disposed to face the guide block 313, more specifically, the guide body 3131, in the direction parallel to the second direction. When neighboring stages 310 move relative to each other in the second direction and the distance between the neighboring stages 310 decreases, the guide block 313 formed on one stage 310 may be inserted into the insertion hole 314 of the other stage. Accordingly, the second portion W2 inserted into the guide groove 3132 may be disposed to face the second surface C2 of the solar cell C.

The bending unit 320 may be disposed to be spaced apart from the stage 310. The bending unit 320 may press the wire W disposed on the first surface C1 of the solar cell C on the stage 310 in the first direction. More specifically, the bending unit 320 may serve as a component for bending and deforming the second portion W2 of the wire W, which protrudes outward from the first surface C1, in the first direction after the transfer of the solar cell C and the wire W is completed by the supply device 10 and the transfer device 20.

Hereinafter, as illustrated in FIGS. 3, 4, and 8, an example in which the bending unit 320 is connected to the transfer main body 210 will be described. However, the bending unit 320 is not limited thereto and may be connected to a separate moving means (not illustrated) which may move to a position above the stage 310.

The bending unit 320 may be provided as a plurality of bending units. Each bending unit 320 may be arranged in the second direction and individually connected to a different transfer main body 210.

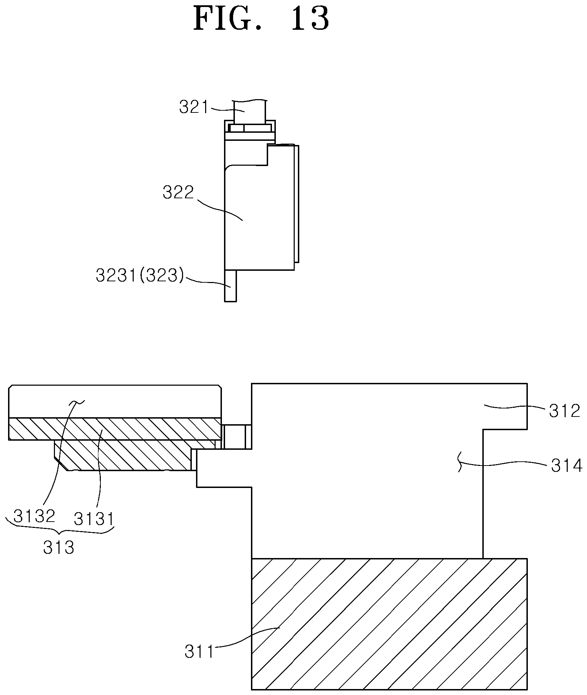

FIG. 13 is a schematic enlarged view illustrating a configuration of a bending unit according to one embodiment of the present disclosure.

Referring to FIGS. 1 to 13, the bending unit 320 according to the present embodiment may include a bending driving unit 321, a bending body 322, and a bending member 323.

The bending driving unit 321 may generate a driving force for operating the bending unit 320. The bending driving unit 321 may be, for example, various types of power devices for generating a driving force by receiving power, hydraulic pressure, or the like from the outside, such as a motor, a cylinder, a solenoid, or the like. The bending driving unit 321 may be connected to and supported by the transfer main body 210.

The bending body 322 may be connected to the bending driving unit 321. The bending body 322 may receive the driving force from the bending driving unit 321 and reciprocate in the direction parallel to the first direction. The bending body 322 according to the present embodiment may be positioned at a position facing the second portion W2 of the wire W in the first direction when the transfer main body 210 seats the wire W and the jig J on the solar cell C. The shape of the bending body 322 is not limited to the shape illustrated in FIG. 13, and the bending body 322 may be designed to have various shapes which can receive the driving force from the bending driving unit 321 and reciprocate in the direction parallel to the first direction.

The bending member 323 may be connected to the bending body 322 and may press or release the pressing of the second portion W2 of the wire W in the first direction in conjunction with the movement of the bending body 322.

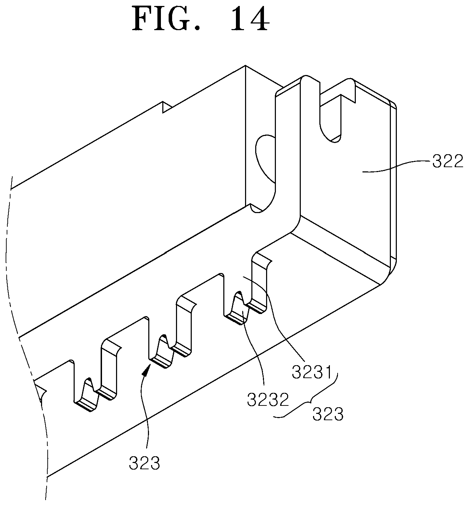

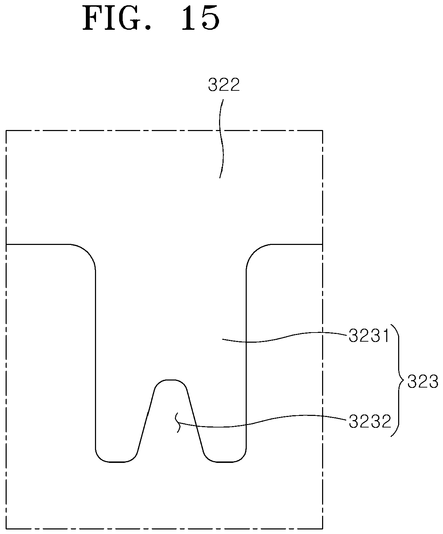

FIG. 14 is a schematic bottom perspective view illustrating a bending member according to one embodiment of the present disclosure, and FIG. 15 is a schematic front view illustrating the configuration of the bending member according to one embodiment of the present disclosure.

The bending member 323 according to the present embodiment may include a first bending rod 3231 and a first groove 3232.

The first bending rod 3231 may extend from the bending body 322 in the first direction. The first bending rod 3231 according to the present embodiment may extend from an end surface of the bending body 322, which directly faces the second portion W2 of the wire W, in the first direction. The first bending rod 3231 may be disposed to be spaced apart from the second portion W2 of the wire W when the bending body 322 is positioned at an initial position, that is, when the bending body 322 completely moves in the direction opposite to the first direction. Accordingly, the first bending rod 3231 can be prevented from interfering with the wire W during the operation of the transfer device 20.

The first bending rod 3231 may be provided as a plurality of first bending rods. The plurality of first bending rods 3231 may be arranged in the third direction. Each first bending rod 3231 may be individually disposed to face the second portion W2 of a different wire W arranged in the third direction when the transfer device 20 transfers the wire W.

The first groove 3232 may be provided in the first bending rod 3231, and when the first bending rod 3231 moves in the first direction, the first groove 3232 may provide a space into which the second portion W2 of the wire W is inserted. The first groove 3232 may serve as a component for aligning the position of the wire W with respect to the first bending rod 3231 when the first bending rod 3231 presses the second portion W2 of the wire W.

The first groove 3232 according to the present embodiment may have the shape of a groove extending from an end portion of the first bending rod 3231 in the direction opposite to the first direction, which faces the second portion W2 of the wire W. The first groove 3232 may pass through both surfaces of the first bending rod 3231 intersecting the second direction. Accordingly, the first groove 3232 can be prevented from interfering with the second portion W2 of the wire W, which extends in the second direction.

The width of the first groove 3232 may be formed to increase in the first direction. The width of one end portion of the first groove 3232 located at an end surface of the first bending rod 3231 may be greater than the diameter of the wire W. Accordingly, when the first bending rod 3231 moves in the first direction, the second portion W2 of the wire W may be smoothly inserted into the first groove 3232. The width of the other end portion of the first groove 3232 located inside the first bending rod 3231 may be smaller than the diameter of the wire W. Accordingly, when the first bending rod 3231 presses the second portion W2 of the wire W in the first direction, the second portion W2 of the wire W may be firmly in close contact with an inner surface of the first groove 3232.

Hereinafter, the operation of the transfer device 20 and the bending device 30 according to one embodiment of the present disclosure will be described.

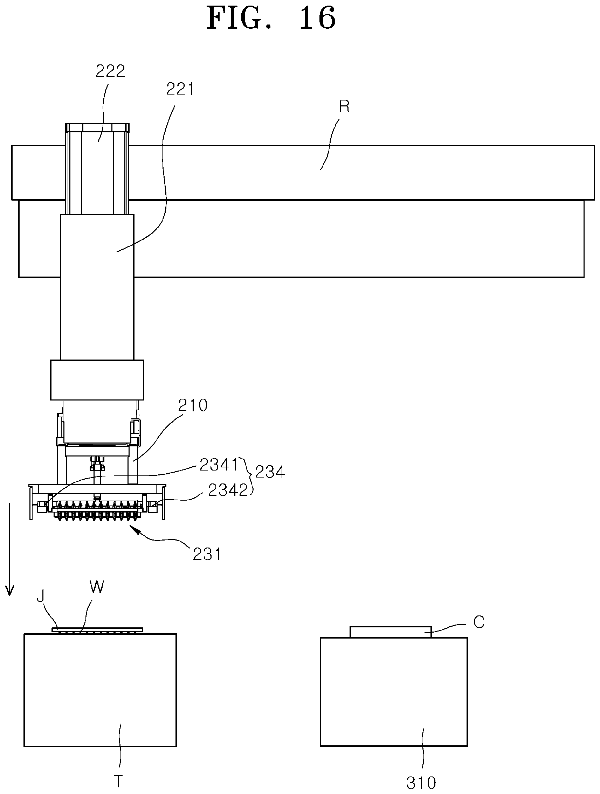

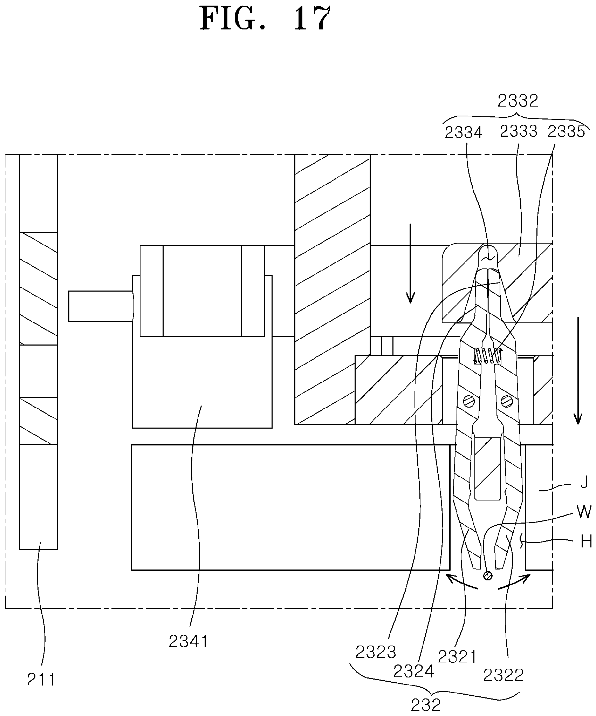

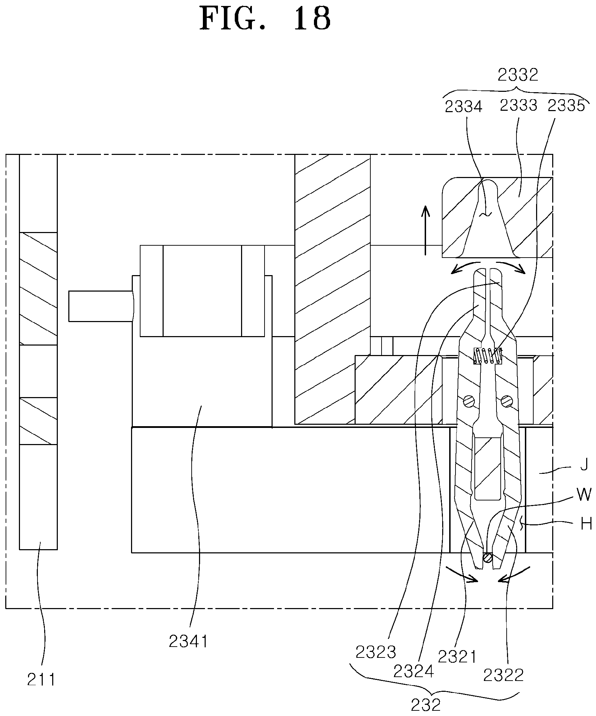

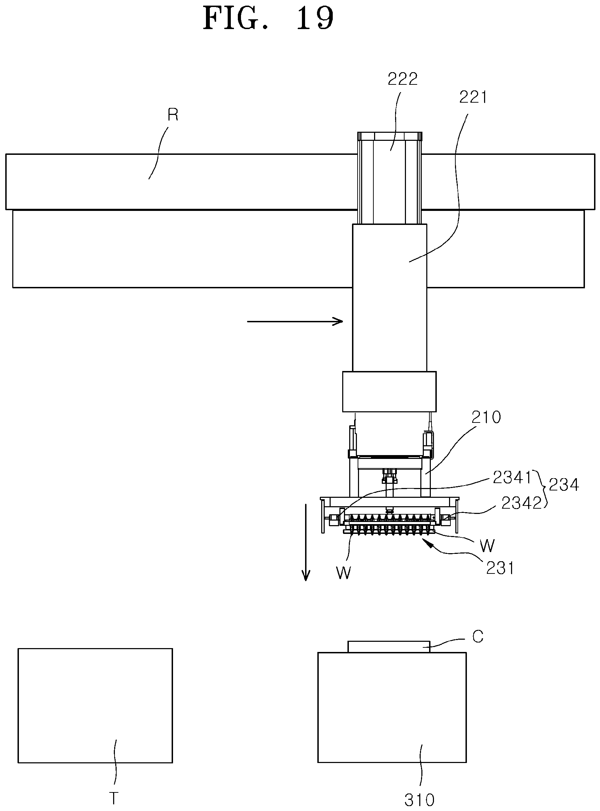

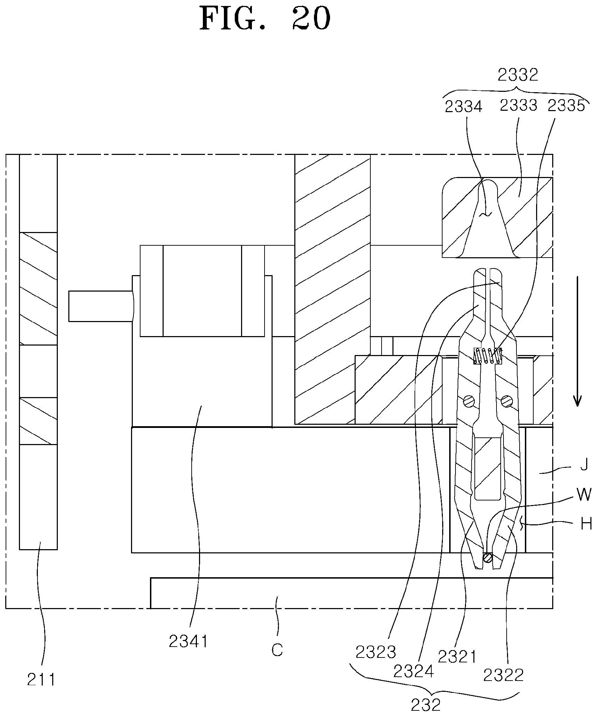

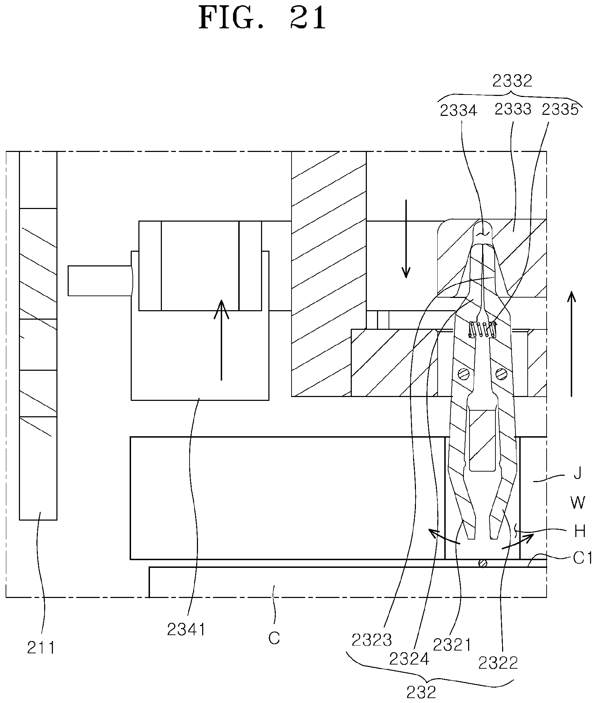

FIGS. 16 to 21 are schematic views illustrating an operation process of the transfer device according to one embodiment of the present disclosure.

Referring to FIGS. 16 to 21, the solar cell C is transferred onto the stage 310, and in a state in which the wire W and the jig J are stacked on the wire-jig table T, the transfer main body 210 moves to a position above the wire-jig table T.

Thereafter, the transfer main body 210 moves in the first direction, and the first jig holder 2341 and the second jig holder 2342 come into contact with the jig J.

The first jig holder 2341 and the second jig holder 2342 generate an electromagnetic force by externally applied power and adsorb the jig J.

As the transfer main body 210 moves in the first direction, the end portions of the first gripper 2321 and the second gripper 2322 are inserted into the through hole H and protrude outward from the jig J.

During this process, the adjustment block 2333 moves in the first direction, and the end portions of the first extension 2323 and the second extension 2324 are inserted into the adjustment groove 2334.

The distance between the first extension 2323 and the second extension 2324 is gradually decreased as the first extension 2323 and the second extension 2324 come into contact with the inner surface of the adjustment groove 2334, and the distance between the first gripper 2321 and the second gripper 2322 increases.

Thereafter, as the support frame 211 is in contact with the wire-jig table T, the first gripper 2321 and the second gripper 2322 may be disposed to face both sides of the wire W at a predetermined distance, respectively.

The adjustment block 2333 moves in the direction opposite to the first direction, and the end portions of the first extension 2323 and the second extension 2324 are separated from the adjustment groove 2334.

The distance between the first extension 2323 and the second extension 2324 is gradually increased by the elastic force of the restoring member 2335.

Accordingly, the distance between the first gripper 2321 and the second gripper 2322 decreases, and the first gripper 2321 and the second gripper 2322 may press both sides of the wire W and grip the wire W.

The transfer main body 210 moves to a position facing the stage 310 on which the solar cell C is seated in the first direction.

As the transfer main body 210 moves in the first direction, the support frame 211 comes into contact with the stage 310, and the wire W is seated on the first surface C1 of the solar cell C.

In this case, the first portion W1 of the wire W is disposed to directly face the first surface C1 of the solar cell C, and the second portion W2 is disposed to protrude from the first surface C1 of the solar cell C in the second direction.

After the wire W is seated on the solar cell C, the adjustment block 2333 moves in the first direction, and the first gripper 2321 and the second gripper 2322 release the gripping state of the wire W.

The power applied to the first jig holder 2341 and the second jig holder 2342 is cut off, and the first jig holder 2341 and the second jig holder 2342 release the adsorption state of the jig J.

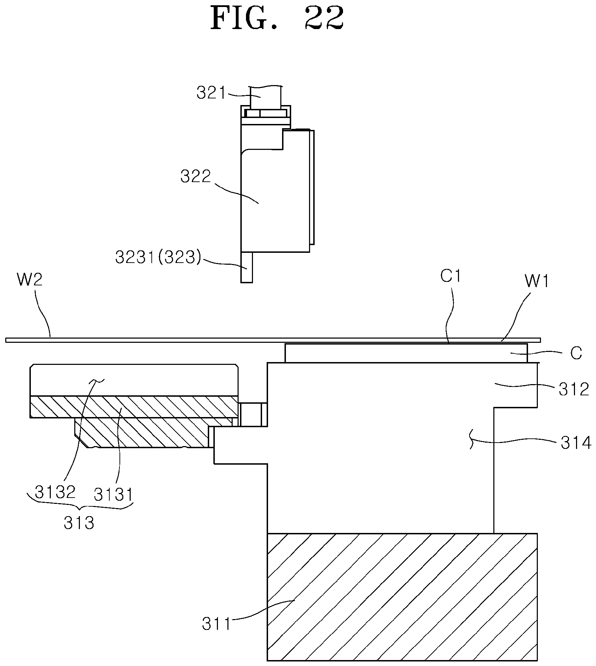

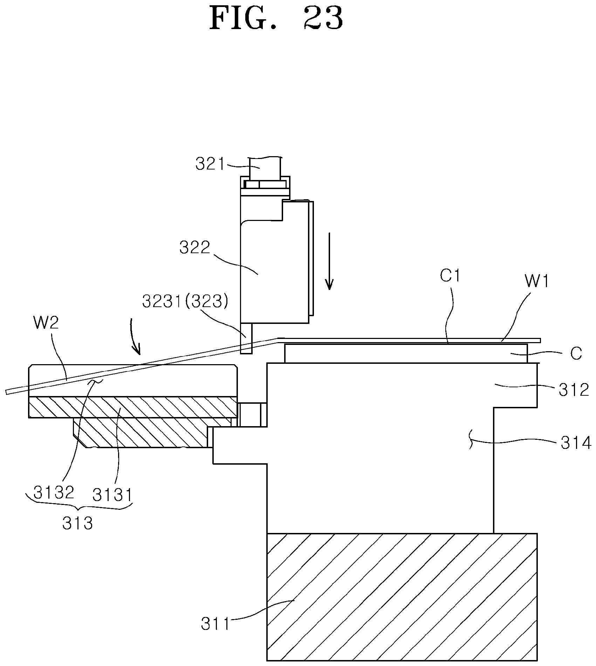

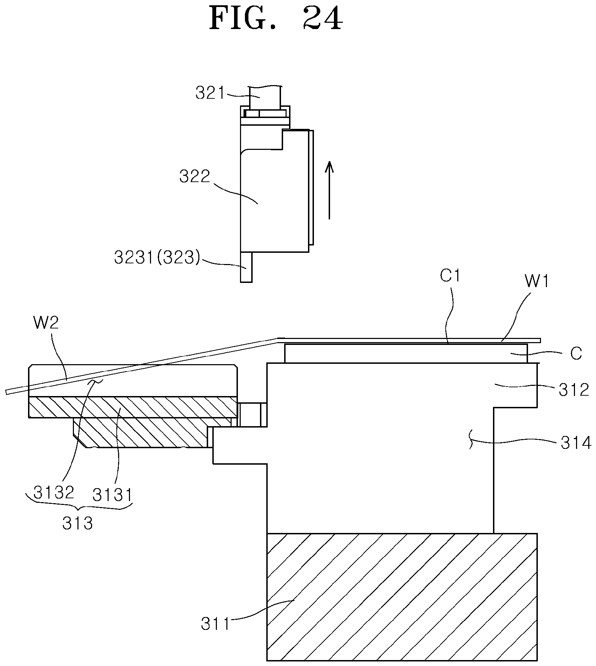

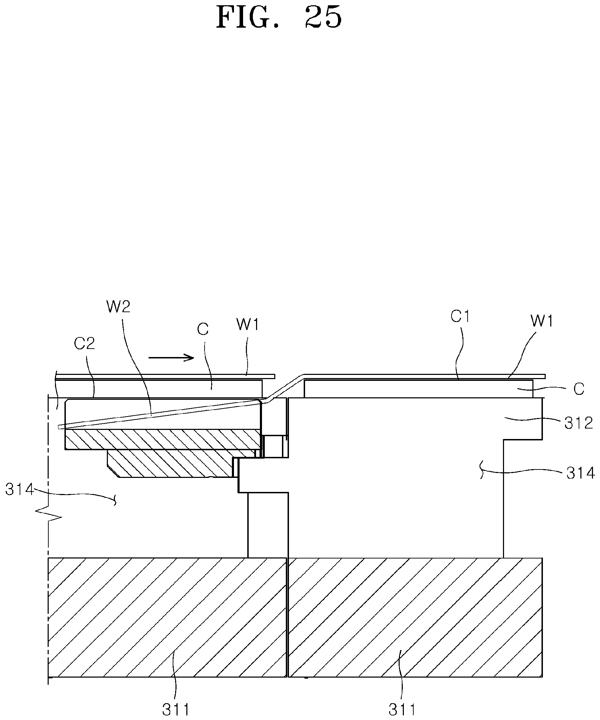

FIGS. 22 to 25 are schematic views showing an operation process of the **bending** device according to one embodiment of the present disclosure.

Referring to FIGS. 22 to 25, after the gripping state of the wire W and the adsorption state of the jig J are released, the bending body 322 receives the driving force from the bending driving unit 321 and moves in the first direction.

As the bending body 322 moves a set distance or more in the first direction, the second portion W2 of the wire W is inserted into the first groove 3232, and the first bending rod 3231 presses the second portion W2 of the wire W in the first direction.

The second portion W2 of the wire W is deformed by being bent in the first direction by the pressing force applied from the first bending rod 3231 and is inserted into the guide groove 3132.

After the bending deformation of the second portion W2 is completed, the bending body 322 moves in the first direction, and the first bending rod 3231 is separated from the second portion W2 of the wire W.

The above operation is performed on the solar cells C and the wires W, which are seated on the plurality of stages 310, in the same manner.

Thereafter, the plurality of stages 310 move relative to each other in the second direction, and the distance between neighboring stages 310 decreases.

The guide block 313 formed on one of a pair of neighboring stages 310 is inserted into the insertion hole 314 of the other, and the second portion W2 inserted into the guide groove 3132 is disposed to face the second surface C2 of the solar cell C.

The bonding device 40 may bond the solar cell C and the wire W. After the operation of the transfer device 20 and the bending device 30, the bonding device 40 may receive the solar cell C, the wire W, and the jig J from the stage 310.

For example, the bonding device 40 may include a conveyor for continuously transferring the solar cell C, the wire W, and the jig J which are received from the stage 310, and a heating device for melting a solder layer of the wires W moved by the conveyor or heating an ECA applied to the connecting portion of the solar cell C and the wire W.

Hereinafter, a tabbing apparatus according to another embodiment of the present disclosure will be described.

The tabbing apparatus according to the present embodiment may be configured to differ only in the detailed configuration of the bending member 323 from the tabbing apparatus according to one embodiment of the present disclosure.

Accordingly, in describing the tabbing apparatus according to the present embodiment, only the detailed configuration of the bending member 323, which differs from that of the tabbing apparatus according to one embodiment of the present disclosure, will be described.

The description of the tabbing apparatus according to one embodiment of the present disclosure may be applied as is to the remaining components of the tabbing apparatus according to the present embodiment.

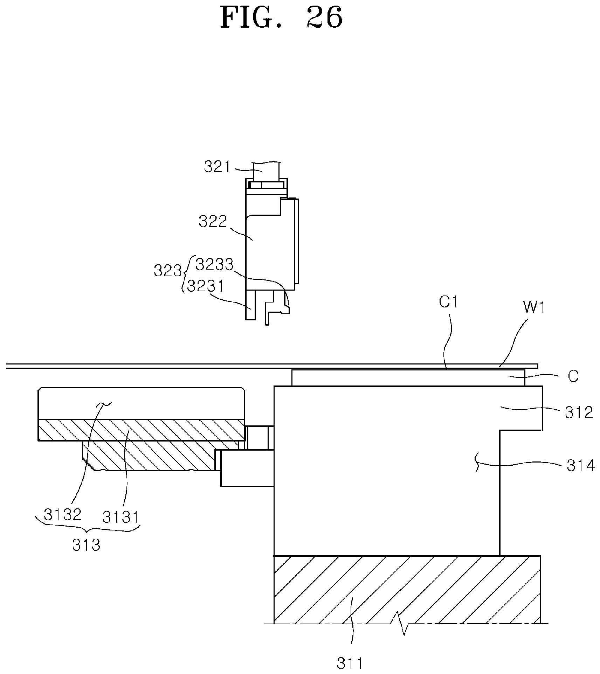

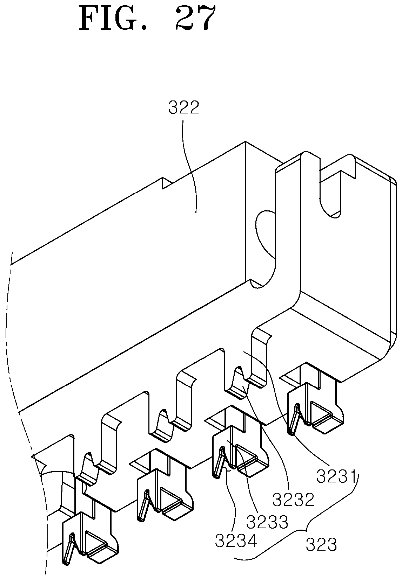

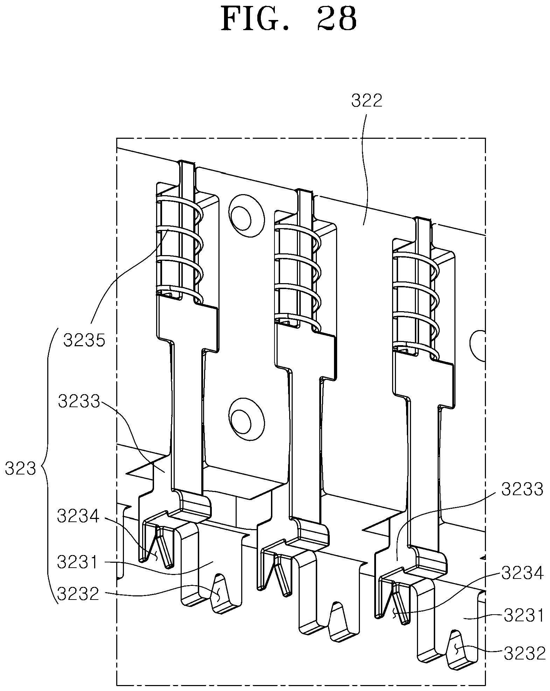

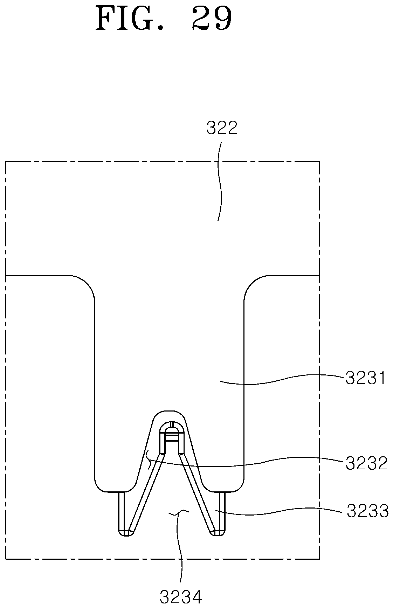

FIG. 26 is a schematic side view illustrating a configuration of a bending member according to another embodiment of the present disclosure, FIG. 27 is a schematic bottom perspective view illustrating the bending member according to another embodiment of the present disclosure, FIG. 28 is a schematic cross-sectional view illustrating the configuration of the bending member according to another embodiment of the present disclosure, and FIG. 29 is a schematic front view illustrating the configuration of the bending member according to another embodiment of the present disclosure.

Referring to FIGS. 26 to 29, the bending member 323 according to the present embodiment may further include a second bending rod 3233 and a second groove 3234.

The second bending rod 3233 may extend from the bending body 322 in the first direction and may be disposed to be spaced apart from the first bending rod 3231.

The second bending rod 3233 according to the present embodiment may extend from the end surface of the bending body 322, which directly faces the second portion W2 of the wire W, in the first direction. The second bending rod 3233 may be disposed to be spaced apart from the second portion W2 of the wire W when the bending body 322 is positioned at the initial position. Accordingly, the second bending rod 3233 can be prevented from interfering with the wire W during the operation of the transfer device 20.

The first bending rod 3231 and the second bending rod 3233 may be spaced apart from each other in the second direction. More specifically, the second bending rod 3233 and the first bending rod 3231 may be sequentially arranged in the second direction.

The second bending rod 3233 may be provided as a plurality of second bending rods. The plurality of second bending rods 3233 may be arranged in the third direction. Each second bending rod 3233 may be individually disposed to face the second portion W2 of a different wire W arranged in the third direction when the transfer device 20 transfers the wire W.

The second groove 3234 may be provided in the second bending rod 3233, and when the second bending rod 3233 moves in the first direction, the second groove 3234 may provide a space into which the second portion W2 of the wire W is inserted. The second groove 3234 may serve as a component for aligning the position of the wire W with respect to the second bending rod 3233 when the second bending rod 3233 presses the second portion W2 of the wire W.

The second groove 3234 according to the present embodiment may have the shape of a groove extending from an end portion of the second bending rod 3233 in the direction opposite to the first direction, which faces the second portion W2 of the wire W. The second groove 3234 may pass through both surfaces of the second bending rod 3233 intersecting the second direction. Accordingly, the second groove 3234 can be prevented from interfering with the second portion W2 of the wire W, which extends in the second direction.

The width of the second groove 3234 may be formed to increase in the first direction. The width of one end portion of the second groove 3234 located at an end surface of the second bending rod 3233 may be greater than the diameter of the wire W. Accordingly, when the second bending rod 3233 moves in the first direction, the second portion W2 of the wire W may be smoothly inserted into the second groove 3234. The width of the other end portion of the second groove 3234 located inside the second bending rod 3233 may be smaller than the diameter of the wire W. Accordingly, when the second bending rod 3233 presses the second portion W2 of the wire W in the first direction, the second portion W2 of the wire W may be firmly in close contact with an inner surface of the second groove 3234. The position of the other end portion of the groove 3234 disposed inside the second bending rod 3233 may be lower than the position of the other end portion of the first groove 3232 disposed inside the first bending rod 3231.

The second bending rod 3233 may be connected to the bending body 322 to be movable in the direction parallel to the first direction. The second bending rod 3233 and the first bending rod 3231 may sequentially come into contact with the second portion W2 of the wire W as the bending body 322 moves in the first direction. More specifically, when the bending body 322 moves in the first direction, the second bending rod 3233 may preferentially come into contact with the second portion W2 of the wire W. Thereafter, the second bending rod 3233 is moved in the direction opposite to the first direction by a reaction force with the wire W or other structures, and the first bending rod 3231 may come into contact with the second portion W2 of the wire W. Accordingly, the second bending rod 3233 may guide the bending direction of the wire W to be aligned in the first direction before the operation of the first bending rod 3231.

The bending member 323 according to the present embodiment may further include an elastic member 3235.

The elastic member 3235 may serve as a component for returning the second bending rod 3233 to an initial position when the second bending rod 3233 is separated from the wire W.

The elastic member 3235 according to the present embodiment may have the form of a coil spring which can be stretched and compressed in the longitudinal direction. The elastic member 3235 may be disposed between the bending body 322 and the second bending rod 3233. The elastic member 3235 may be formed to have a longitudinal direction parallel to the first direction and may have both end portions respectively connected to the bending body 322 and the second bending rod 3233. The elastic member 3235 may be installed to apply an elastic force to the second bending rod 3233 in the first direction when no separate external force is applied to the second bending rod 3233.

Hereinafter, the operation of a bending device according to another embodiment of the present disclosure will be described.

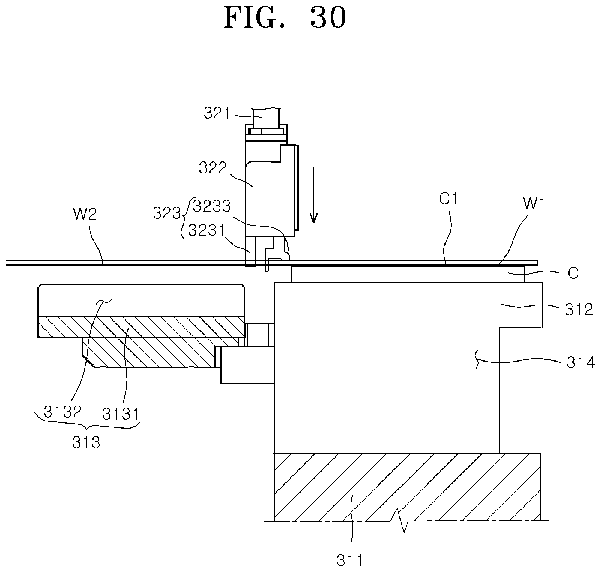

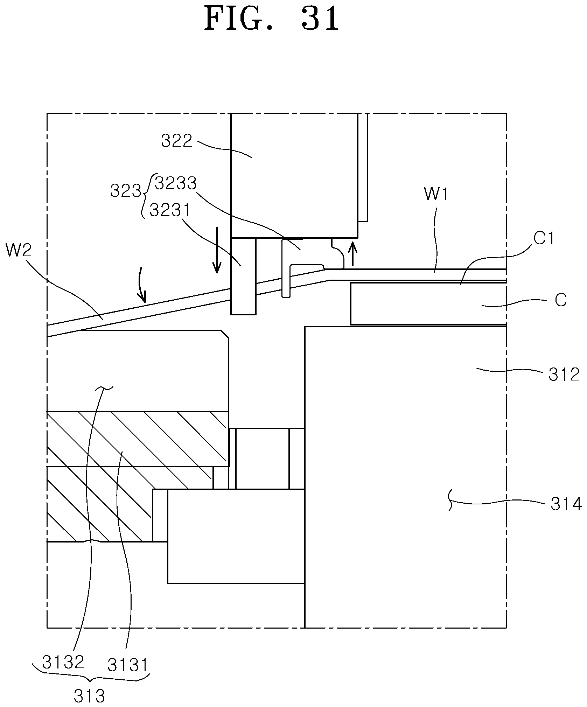

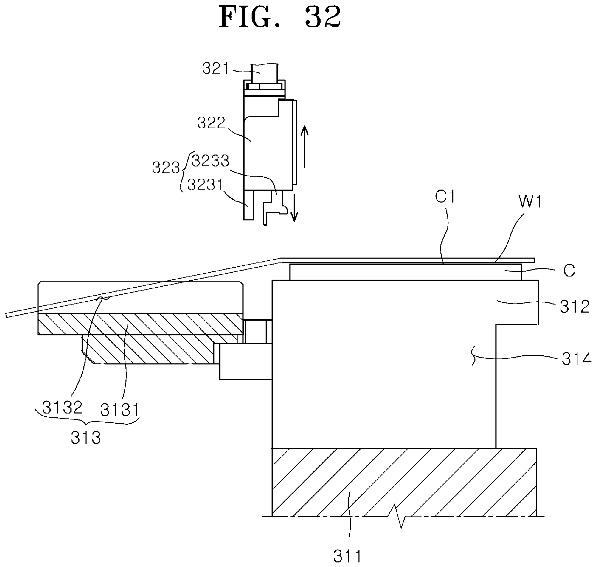

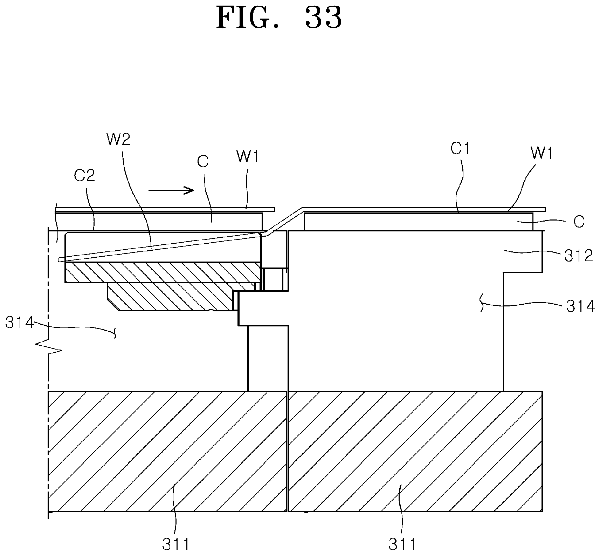

FIGS. 30 to 33 are schematic views illustrating an operation process of a bending device according to another embodiment of the present disclosure.

Referring to FIGS. 30 to 33, after the gripping state of the wire W and the adsorption state of the jig J are released, the bending body 322 receives the driving force from the bending driving unit 321 and moves in the first direction.

As the bending body 322 moves a set distance or more in the first direction, the second portion W2 of the wire W is inserted into the second groove 3234, and the second bending rod 3233 presses the second portion W2 of the wire W in the first direction and aligns the bending direction of the wire W in the first direction.

The second bending rod 3233 is moved in the first direction by the reaction force acting between the second bending rod 3233 and the wire W.

Thereafter, the second portion W2 of the wire W is inserted into the first groove 3232, and the first bending rod 3231 presses the second portion W2 of the wire W in the first direction.

The second portion W2 of the wire W is deformed by being bent in the first direction by the pressing force applied from the first bending rod 3231 and is inserted into the guide groove 3132.

After the bending deformation of the second portion W2 is completed, the bending body 322 moves in the first direction, and the first bending rod 3231 and the second bending rod 3233 are separated from the second portion W2 of the wire W.

As the second bending rod 3233 is separated from the second portion W2 of the wire W, the second bending rod 3233 returns to the initial position by the elastic force of the elastic member 3235.

The above operation is performed on the solar cells C and the wires W, which are seated on the plurality of stages 310, in the same manner.

Thereafter, the plurality of stages 310 move relative to each other in the second direction, and the distance between neighboring stages 310 decreases.

The guide block 313 formed on one of a neighboring pair of stages 310 is inserted into the insertion hole 314 of the other, and the second portion W2 inserted into the guide groove 3132 is disposed to face the second surface C2 of the solar cell C.

According to the present disclosure, during a process of pressing wires, contact positions of the wires with a first bending member can be aligned to correct positions and a uniform pressing force can be applied to the wires due to a first groove formed in a first bending rod.

According to the present disclosure, a bending direction of the wire can consistently proceed along a set path due to a guide block which guides the movement of the wires bent in a first direction.

According to the present disclosure, since a plurality of stages are provided to overlap each other, after the bending of the wire is completed, second portions of the plurality of wires can be disposed to face a second surface of a solar cell at the same time by the relative movement between the stages, thereby further increasing process efficiency.

According to the present disclosure, during the bending operation of the wire, the bending direction of the wire can be guided to be aligned in the first direction by a second bending rod coming into contact with the wire earlier than a first bending rod.

Although the present disclosure has been described with reference to embodiments illustrated in the drawings, the embodiments are merely illustrative, and those skilled in the art will understand that various modifications and equivalent other embodiments are possible therefrom.

Accordingly, the technical scope of the present disclosure should be determined by the appended claims.

## Claims

1. A bending device comprising:
a stage on which a solar cell having a first surface and a second surface spaced apart from each other in a first direction is seated; and
a bending unit spaced apart from the stage and configured to press a wire disposed on the first surface in the first direction.

2. The bending device of claim 1, wherein the wire includes:
a first portion disposed to face the first surface; and
a second portion extending from the first portion in a second direction intersecting the first direction and protruding outward from the first surface, and
the bending unit presses the second portion.

3. The bending device of claim 2, wherein the bending unit includes:
a bending driving unit configured to generate a driving force;
a bending body connected to the bending driving unit and configured to receive the driving force from the bending driving unit and reciprocate in a direction parallel to the first direction; and
a bending member connected to the bending body and configured to press the second portion in the first direction in conjunction with movement of the bending body.

4. The bending device of claim 3, wherein the bending member includes:
a first bending rod extending from the bending body in the first direction; and
a first groove which extends from an end portion of the first bending rod in a direction opposite to the first direction and into which the second portion is inserted.

5. The bending device of claim 4, wherein the bending member further includes:
a second bending rod extending from the bending body in the first direction and spaced apart from the first bending rod; and
a second groove which extends from an end portion of the second bending rod in the direction opposite to the first direction and into which the second portion is inserted.

6. The bending device of claim 5, wherein the first bending rod and the second bending rod are spaced apart from each other in the second direction.

7. The bending device of claim 5, wherein the second bending rod is connected to the bending body to be movable in the direction parallel to the first direction.

8. The bending device of claim 5, wherein the second bending rod and the first bending rod sequentially come into contact with the second portion as the bending body moves in the first direction.

9. The bending device of claim 8, wherein the bending member further includes an elastic member disposed between the bending body and the second bending rod.

10. The bending device of claim 2, wherein the stage includes:
a stage main body;
a support block extending from the stage main body to be in contact with the second surface; and
a guide block extending from the support block and configured to guide movement of the second portion bent in the first direction.

11. The bending device of claim 10, wherein the guide block includes:
a guide body extending from the support block in the second direction; and
a guide groove which is disposed inside the guide body and into which the second portion bent in the first direction is inserted.

12. The bending device of claim 10, wherein the stage is provided as a plurality of stages arranged in the second direction, and each of the stages supports a different solar cell.

13. The bending device of claim 12, wherein the stage is movable in a direction parallel to the second direction.

14. The bending device of claim 13, wherein the stage further includes an insertion hole formed to be concavely recessed inward of the stage main body and disposed to face the guide block.

15. A tabbing apparatus comprising:
a supply device configured to supply a solar cell and a wire;
a transfer device configured to seat the wire on the solar cell;
a bending device configured to perform bending of the wire seated on the solar cell; and
a bonding device configured to bond the solar cell and the wire,
wherein the bending device includes:
a stage on which a solar cell having a first surface and a second surface spaced apart from each other in a first direction is seated; and
a bending unit spaced apart from the stage and configured to press the wire disposed on the first surface in the first direction.
